Europäisches Patentamt

European Patent Office

Office européen des brevets

(11) Publication number: **0 080 874**
**B1**

(12) **EUROPEAN PATENT SPECIFICATION**

(45) Date of publication of patent specification: **30.03.88**

(21) Application number: **82306311.0**

(22) Date of filing: **26.11.82**

(51) Int. Cl.⁴: **H 03 K 19/003,** H 03 K 17/22

(54) Error prevention in TTL circuits.

(30) Priority: **30.11.81 JP 192443/81**

(43) Date of publication of application:
**08.06.83 Bulletin 83/23**

(45) Publication of the grant of the patent:
**30.03.88 Bulletin 88/13**

(84) Designated Contracting States:
**DE FR GB**

(56) References cited:
**DE-A-3 019 235**
**US-A-4 254 347**

**COMPUTER DESIGN, vol. 11, no. 6, June 1972,
pages 82-86, Concord, USA; J.E. BUCHANAN:
"A normally "ON" FET control circuit for TTL
logic systems"**

**IBM TECHNICAL DISCLOSURE BULLETIN, vol.
20, no. 6, November 1977, pages 2370-2371,
New York, USA; C.R. HOFFMAN: "Anti-glitch
circuit"**

(73) Proprietor: **FUJITSU LIMITED**
**1015, Kamikodanaka Nakahara-ku
Kawasaki-shi Kanagawa 211 (JP)**

(72) Inventor: **Suzuki, Hirokazu
Sani-haitsu 507 2-13-18, Chuo
Yamato-shi Kanagawa 242 (JP)**
Inventor: **Akiyama, Takehiro Fujitsu Dai-1
Ichigao-Ryo
2-2-5, Eda Kita, Midori-ku
Yokohama-shi Kanagawa 227 (JP)**

(74) Representative: **Fane, Christopher Robin King
et al
HASELTINE LAKE & CO. Hazlitt House 28
Southampton Buildings Chancery Lane
London, WC2A 1AT (GB)**

(56) References cited:
**"Analysis and Design of Integrated Circuits", by
Lynn Meyer and Hamilton (USA, 1967)**

Note: Within nine months from the publication of the mention of the grant of the European patent, any person may
give notice to the European Patent Office of opposition to the European patent granted. Notice of opposition shall
be filed in a written reasoned statement. It shall not be deemed to have been filed until the opposition fee has been
paid. (Art. 99(1) European patent convention).

## Description

This invention relates to TTL (Transistor Transistor Logic) circuits and more particularly to the prevention of errors in the operation of such circuits, for example when first switched on.

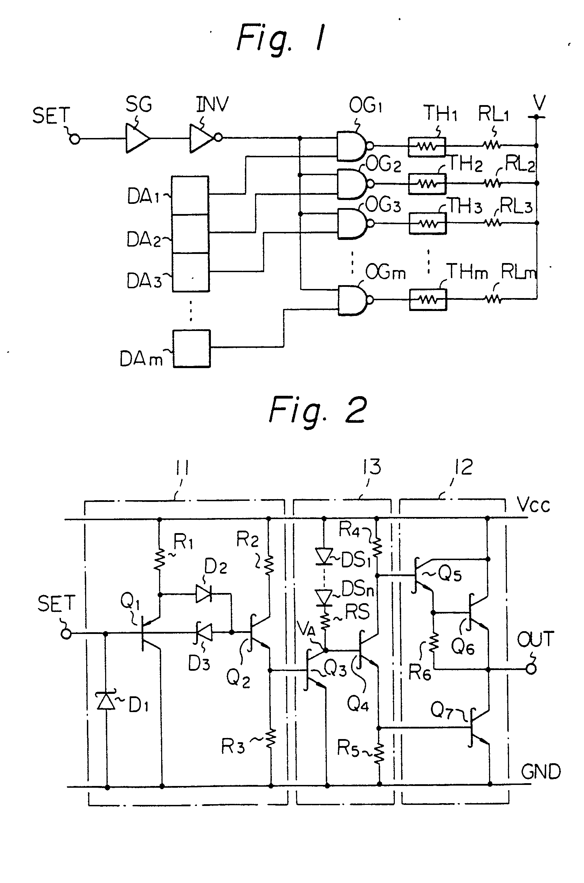

In, for example, a facsimile machine of the thermosensitive printer type, the enable period of the thermal heads of the printer is usually controlled by the output of a gate circuit called a "set gate". A driving circuit for the thermal heads is illustrated in Fig. 1 of the accompanying drawings. In Fig. 1, SG indicates a set gate circuit, INV indicates an inverter circuit, DA1 to DAm are data latch circuits, OG1 to OGm are output gate circuits with NAND logic, TH1 to THm are thermal heads, and RL1 to RLm are resistors providing current limiting. The set gate circuit SG is a TTL logic circuit which receives a signal from an external set input SET indicating whether an operation can be effected or not, and generates an output signal having the same logic level as the set signal. The inverter circuit INV inverts the output of the set gate circuit SG, and the output of the inverter is supplied to all of the output gate circuits OG1 through OGm.

When the set input SET is high or "H", the output of the inverter circuit INV is low or "L", all of the outputs of the output gate circuits OG1 to OGm are "H" and no current flows through any of the thermal heads TH1 to THm. On the other hand, when the set input SET is "L", the output of the inverter circuit INV is "H" and, when the output of the corresponding data latch is "L", the output of each of the output gate circuits OG1 to OGm is "H". When the output of the corresponding data latch circuit is "H", of course, the output is "L". When the output of the output gate circuit OGi is "L", current flows through the thermal head THi and the character corresponding to the output data of the latch circuit is printed.

In the driver circuit of Fig. 1, there may be the following problem immediately after the power supply is turned on. The set input SET should be kept at "H" until the printed data is set into the latch circuits DA1 to DAn and the printing operation is instructed. However, in a transition condition, such as when turning on the power supply, the set input SET may not settle into either "H" or "L". Thus, it is not certain if the output of the set gate circuit SG will become "H" or "L" i.e., it may become "H" or "L" randomly. If the output of the set gate SG becomes "L", then the output of the inverter circuit INV becomes "H". In this condition, if any one of the data outputs of the latch circuits DA1 to DAm is "H", then the output of the corresponding output gate circuit becomes "L" and a current flows through the corresponding thermal head. Since the current flowing through the thermal head is considerably large, even only a few milliseconds of current may result in printing. Thus, stain-like undesirable printing may take place on the paper in the transition period when turning on the power supply.

A known TTL gate circuit, disclosed for example on page 312 of "Analysis and Design of Integrated Circuits" by Lynn, Meyer and Hamilton (USA, 1967), has an output transistor for providing an output signal which undergoes a predetermined change in response to a predetermined change in an input signal applied to the circuit. This known circuit includes a control transistor, connected to control the output transistor and arranged in a phase-splitting configuration, whose base is connected to receive a signal which changes in response to the said predetermined change in the input signal. In this particular gate circuit, the control transistor is rendered conductive by the application of a high voltage to its base. Current then flows through the control transistor, via a resistor, from a power supply line to the base of the output transistor, which causes the output transistor to be rendered conductive. This, in turn, causes the output signal to be pulled "LOW".

However, in this known TTL circuit, at a time before the power supply has reached its normal steady-state value, the input signal may become "HIGH" before it should, thereby causing the output signal to become "LOW" erroneously. An incorrect signal would therefore be sent to any load driven by the gate circuit and this may have undesirable results. This known TTL circuit is not, however, provided with any means for preventing such erroneous operation.

According to the present invention, there is provided TTL circuitry controllable by an input signal so that when the circuit is in a normal steady-state operating condition an output signal provided by an output transistor thereof will undergo a predetermined change in response to a predetermined change in the input signal, the said circuitry including a control transistor connected to control the said output transistor and having its base connected to receive a signal which, in the normal operating condition, will change in response to the said predetermined change in the input signal;

characterised by error prevention means comprising at least one semiconductor junction device connected in series with the base-emitter path of the control transistor across the power supply of the circuitry so as to prevent the occurrence of such a change in the output signal, in response to the said predetermined change in the input signal, if the power supply voltage applied to the circuitry is below a threshold value determined by the said error prevention means.

Reference will now be made, by way of example, to the accompanying drawings, in which:

Figure 1 (described above) is a block circuit diagram illustrating driver circuitry for a thermal head driver;

Figure 2 is a circuit diagram of TTL circuitry embodying the present invention; and

Figure 3 is a graph of voltage waveforms in the TTL circuitry of Figure 2 when power is supplied thereto.

The TTL circuit shown in Fig. 2 can be used as the set gate circuit SG of Fig. 1 and comprises an input circuit 11, an output circuit 12, and a control/error prevention circuit 13. The input circuit 11 has transistors Q1 and Q2; diodes D1, D2, and D3; and resistors R1, R2, and R3. The output circuit 12 has transistors Q5, Q6, and Q7 and a resistor R6. The control circuit 13 has transistors Q3 and Q4; diodes DS1 to DSn; and resistors RS, R4, and R5.

A setting input SET is supplied to the base of the transistor Q1. In steady-state operation, when the set input SET is "L", the current flowing from the voltage supply Vcc through the resistor R1 flows from the emitter of the pnp transistor Q1 to its collector and the base potential of the transistor Q2 becomes low. Therefore, the transistors Q2 and Q3 become off. Accordingly, the current flowing from the voltage supply Vcc through the diodes DS1, ..., DSn and resistor RS flows into the base of the control transistor Q4, which is connected in a phase splitter configuration. Thus, the control transistor Q4 becomes on, and the output transistor Q7, whose base is connected to the emitter of the transistor Q4 and whose emitter is connected to the ground, becomes on. On the other hand, the transistors Q5 and Q6, of a Darlington-connection type, whose base-emitter paths are connected in series to the collector of the transistor Q4, become off. Thus, the output OUT becomes "L".

When the set input SET is "H", the transistor Q1 becomes off and the current flowing from the voltage supply Vcc through the resistor R1 flows through the diode D2 into the base of the transistor Q2. Thus, the transistor Q2 becomes on and the transistor Q3 becomes on. Therefore, the base potential of the control transistor Q4 becomes low. Accordingly, the control transistor Q4 becomes off, and the output transistor Q7 becomes off. On the other hand, the Darlington-connection type transistors Q5 and Q6 become on, and the output OUT becomes "H".

From the circuitry shown in Fig. 2 it will be appreciated that, in order to turn on the output transistor Q7, it is necessary for the base potential of the control transistor Q4 to be increased to more than twice the base-emitter voltage $V_{BE}$, i.e. $2 V_{BE}$. If the base of the control transistor Q4 were connected to the voltage supply Vcc merely through a resistor (for example as in the gate circuit shown on page 312 of "Analysis and Design of Integrated Circuits" by Lynn, Meyer and Hamilton, Motorola, USA, 1967), when power is first applied to the circuit the control transistor Q4 could be turned on when the voltage supply Vcc has risen to only $Vcc > 2 V_{BE}$, thereby causing the output OUT to be "L" transiently well before the supply voltage has reached its normal steady-state value.

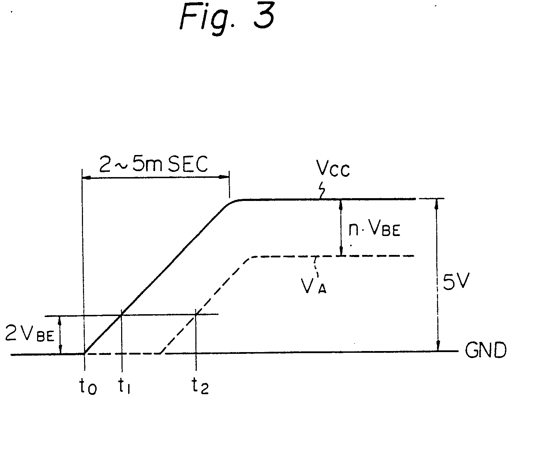

In the TTL circuit of Fig. 2, however, the base of the transistor Q4 is connected to the voltage supply Vcc through the diodes DS1 to DSn and the resistor RS, so that the base potential of the transistor Q4 cannot rise above $2 V_{BE}$ until the voltage supply Vcc rises up to a sufficiently high level after turning on. The waveform of the voltage supply Vcc at the turning-on time is illustrated in Fig. 3 by a continuous line. As seen from Fig. 3, the voltage supply Vcc is turned on at the time $t_0$ and rises up to 5V in 2 to 5 milliseconds. The broken line of Fig. 3 illustrates the upper limit of the base potential $V_A$ of the transistor Q4. The voltage supply Vcc becomes $2 V_{BE}$ at the time $t_1$, and the voltage $V_A$ becomes $2 V_{BE}$ at the time $t_2$. The final upper limit of the voltage $V_A$ is lower than the voltage supply Vcc by $n \cdot V_{BE}$ (n being the number of the diodes DS1 to DSn, and $V_{BE}$ being here the forward voltage of each diode).

During the period from $t_0$ to $t_1$, all the output transistors Q5, Q6, and Q7 are off, and the output OUT is in a high impedance state. During the period from $t_1$ to $t_2$, the base voltage of the transistor Q4 is lower than $2 V_{BE}$. Therefore, the output transistor is off, irrespective of the set input SET and the output OUT is forced to be effectively "H". The set input SET, which is produced by an external TTL circuit, reaches a steady value "H" after a time $t_x$ after the time $t_1$. Accordingly, by selecting the time $t_2$ to be after $t_x$, the output OUT is kept at "H" from the time of turning on to the time (after $t_x$) when the set input SET is deliberately changed to "L". Thus, even if the set input SET may become "L" unexpectedly in the transition time from $t_0$ to $t_x$, this "L" level does not appear in the output OUT.

The number n of the diodes DS1 to DSn required can be determined by the following equation:

$$Vcc - n \cdot V_{BE} > 2 V_{BE}$$

Assuming $V_{BE} = 0.8$ V, Vcc = 5 V, then $n \leq 4$. In the case of n=4, the output OUT is forced to be "L" until the voltage supply Vcc rises up to 4.8 V. In the case of n=3, the output OUT is forced to be "H" until the voltage supply Vcc rises up to 4.0 V.

If the TTL circuit of Fig. 2 is used as the set gate circuit SG of Fig. 1, the outputs of the output gate circuits OG1 to OGm are kept at "H" forcibly immediately after the turning-on of the voltage source, so that current is prevented from flowing through the thermal heads TH1 to THm. A TTL circuit embodying the present invention, however, can be used for many purposes other than in a thermal head driver.

In an embodiment of the present invention, the output of the TTL circuit can be securely kept at "H" immediately after the voltage supply is turned on.

**Claims**

1. TTL circuitry controllable by an input signal so that when the circuit is in a normal steady-state operating condition an output signal provided by an output transistor (Q7) thereof will undergo a predetermined change in response to a predetermined change in the input signal, the said circuitry including a control transistor (Q4) connected to control the said output transistor (Q7) and having its base connected to receive a signal which, in the normal operating condition, will change in response to the said predetermined change in the input signal;

characterised by error prevention means comprising at least one semiconductor junction device (DS$_1$, . . ., DS$_n$) connected in series with the base-emitter path of the control transistor (Q4) across the power supply (Vcc-GND) of the circuitry so as to prevent the occurrence of such a change in the output signal, in response to the said predetermined change in the input signal, if the power supply voltage (Vcc) applied to the circuitry is below a threshold value determined by the said error prevention means (DS$_1$, . . ., DS$_n$).

2. Circuitry as claimed in claim 1, wherein the said means comprise a plurality of diodes (DS$_1$, . . ., DS$_n$) connected, in series with one another, between the base of the control transistor (Q4) and a power supply line of the circuitry so that the said control transistor is kept non-conductive, so as to maintain the said output signal at "HIGH", until the said power supply voltage rises above the said threshold value, whereafter the control transistor can be rendered conductive in respect to the said predetermined change in the input signal thereby to change the said output signal to "LOW".

3. Circuitry as claimed in claim 1 or 2, wherein the said control transistor (Q4) is connected in a phase-splitting configuration, the emitter and collector of the transistor being connected through respective resistors (R$_4$, R$_5$) to respective power supply lines of the circuitry.

**Patentansprüche**

1. TTL-Schaltung, die durch ein Eingangssignal steuerbar ist, so daß dann, wenn die Schaltung in ihrem normalen Dauerzustands-Betriebszustand ist, ein Ausgangssignal, welches von einem Ausgangstransistor (Q7) von ihr geliefert wird, einer vorbestimmten Veränderung unterliegt, in Abhängigkeit von einer vorbestimmten Änderung des Eingangssignals, wobei die genannte Schaltung einen Steuertransistor (Q4) enthält, der zur Steuerung des genannten Ausgangstransistors (Q7) angeschlossen ist und dessen Basis angeschlossen ist, um ein Signal zu empfangen, welches, in dem normalen Betriebszustand, sich in Abhängigkeit von der genannten vorbestimmten Änderung des Eingangssignals ändert; gekennzeichnet durch eine Fehlerverhinderungseinrichtung, welche wenigstens eine Halbleiterübergangseinrichtung (DS$_1$, . . ., DS$_n$) umfaßt, die in Reihe mit dem Basis-Emitter-Weg des Steuertransistors (Q4) zwischen der Energieversorgung (Vcc-Erde) der Schaltung angeschlossen ist, um so das Auftreten von solch einer Änderung in dem Ausgangssignal zu verhindern, in Abhängigkeit von der genannten Änderung des Eingangssignals, falls die Energieversorgungsspannung (Vcc), die der Schaltung zugeführt wird, unterhalb eines Schwellenwertes liegt, der durch die genannte Fehlerverhinde-

rungseinrichtung (DS$_1$, . . ., DS$_n$) bestimmt wird.

2. Schaltung nach Anspruch 1, bei der die genannte Einrichtung eine Vielzahl von Dioden (DS$_1$, . . ., DS$_n$) umfaßt, die in Reihe miteinander zwischen der Basis des Steuertransistors (Q4) und einer Energievorsorgungsleitung der Schaltung verbunden sind, so daß der genannte Steuertransistor nichtleitend gehalten wird, um so das genannte Ausgangssignal auf "HOCH" zu halten, bis die genannte Energieversorgungsspannung oberhalb des genannten Schwellenwertes ansteigt, woraufhin der Steuertransistor in bezug auf die vorgenannte Änderung in dem Eingangssignal leitend gemacht werden kann, um dadurch das genannte Ausgangssignal auf "NIEDRIG" zu ändern.

3. Schaltung nach Anspruch 1 oder 2, bei der der genannte Steuertransistor (Q4) in einer Phasenteilerkonfiguration angeschlossen ist, der Emitter und der Kollektor des Transistors über jeweilige Widerstände (R$_4$, R$_5$) mit jeweiligen Energieversorgungsleitungen der Schaltung verbunden sind.

**Revendications**

1. Circuit TTL contrôlable par un signal d'entrée de sorte que, lorsque le circuit est dans un état normal de fonctionnement à l'état stable, un signal de sortie fourni par un transistor de sortie (Q7) de celui-ci subit une variation prédéterminée en réponse à une variation prédéterminée du signal d'entrée, ledit circuit incluant un transistor de commande (Q4) connecté pour recevoir un signal qui, dans l'état normal de fonctionnement, varie en réponse à la variation prédéterminée du signal d'entrée;

caractérisé par des moyens de prévention d'erreurs comprenant au moins un dispositif à jonction à semiconducteur (DS$_1$, . . ., DS$_n$) connecté en série avec le chemin de base-émetteur du transistor de commande (Q4) à travers la source de tension d'alimentation (Vcc-MASSE) du circuit de manière à empêcher l'apparition de cette variation du signal de sortie, en réponse à la variation prédéterminée du signal d'entrée, si la tension de source d'alimentation (Vcc) appliquée au circuit est inférieure à une valeur de seuil déterminée par les moyens de prévention d'erreurs (DS$_1$, . . ., DS$_n$).

2. Circuit selon la revendication 1, dans lequel lesdits moyens comprennent un ensemble de diodes (DS$_1$, . . ., DS$_n$) connectées en série entre elles, entre la base due transistor de commande (Q4) et une ligne de tension d'alimentation dudit circuit de sorte que le transistor de commande est maintenu non-conducteur, de manière à maintenir le signal de sortie à un niveau "HAUT", jusqu'à ce que la tension de source d'alimentation d'élève au-dessus de la valeur de seuil, après quoi le transistor de commande peut être rendu conducteur par rapport à la variation prèdéterminée du signal d'entrée pour faire passer de la sorte le signal de sortie à un niveau "BAS".

3. Circuit selon l'une quelconque des revendications 1 et 2, dans lequel le transistor de commande (Q4) est connecté dans une configuration de déphasage, l'émetteur et le collecteur du transistor étant connectés par des résistances respectives (R₄, R₅) aux lignes de tension d'alimentation dudit circuit.

## Fig. 1

## Fig. 2

# Fig. 3